# EUROPEAN PATENT APPLICATION

(11) **EP 4 617 600 A1**
(43) Date of publication of application: **17.09.2025**
(21) Application number: 25162262.7
(22) Date of filing: 07.03.2025
(51) Int. Cl.: F28D 15/02, F28D 15/04, H01L 23/427

(54) **COMMUNICATION-TYPE THERMAL CONDUCTION DEVICE**

(30) Priority: 11.03.2024 CN 202420467861 U
(71) Applicant: Purple Cloud Development Pte. Ltd., Singapore 128424 (SG)
(72) Inventor: Wang, Xue Mei, Hui Zhou City (CN)
(74) Representative: Grünecker Patent- und Rechtsanwälte PartG mbB

(57) **Abstract**

A communication-type thermal conduction device includes a vapor chamber with a heat conduction chamber and at least one first capillary structure. A bridging recess portion is formed on a side of the heat conduction chamber, and the first capillary structure is stacked within the heat conduction chamber and extends to the bridging recess portion. The communication-type thermal conduction device further includes a heat pipe with a heat pipe body and at least one capillary structure. The heat pipe body is stacked on the first capillary structure of the heat conduction chamber at the bridging recess portion, and the second capillary structure is stacked within the heat pipe body and is connected to the first capillary structure.

## Description

### BACKGROUND

The present invention relates to a heat transfer device, particularly a communication-type thermal conduction device that enables the capillary structures of a vapor chamber and a heat pipe to connect and communicate with each other.

To dissipate the heat generated by a heat source, the current heat transfer devices utilize a combination of a heat conduction plate and heat pipes, along with heat sinks (e.g., fins and fans) for heat dissipation. For example, the heat conduction plate contacts the heat source, while the heat pipe connects the heat conduction plate and the heat sink, transferring heat from the heat source to the heat conduction plate and then to the heat sink for heat dissipation.

However, the heat conduction plate and the heat pipe operate independently in the current heat transfer device. For example, the capillary structures of the heat conduction plate are not connected to the heat pipe, resulting in each component conducting heat individually and separately. Therefore, the heat dissipation effect is not fully utilized, and the reflux speed of the liquid working fluid is not effectively improved.

### SUMMARY

The present disclosure provides a communication-type thermal conduction device and its manufacturing method, allowing the capillary structures of the heat pipe and vapor chamber to interconnect, achieving integrated heat transfer and fully realizing the heat dissipation potential of both components.

The invention is as defined in the appended claims. Aspects of the present disclosure provide a communication-type thermal conduction device. The communication-type thermal conduction device includes a vapor chamber that has a heat conduction chamber and at least one first capillary structure, wherein the heat conduction chamber includes a bridging recess portion located on a side thereof, and the first capillary structure is disposed within the heat conduction chamber and extends into the bridging recess portion, a heat pipe that includes a heat pipe body and at least one capillary structure, wherein the heat pipe body is stacked on the first capillary structure of the heat conduction chamber at the bridging recess portion, and the second capillary structure is disposed within the heat pipe body and is connected to the first capillary structure.

In one embodiment, the communication-type thermal conduction device further comprises a bonding layer, wherein a first side of the bonding layer is connected to the first capillary structure through metallic bonding, and the second side of the bonding layer is connected to the second capillary structure through metallic bonding.

In one embodiment, the bonding layer is made of pre-sintered powder.

In one embodiment, the bonding layer is composed of gold, silver, copper, or iron powder.

In one embodiment, the first capillary structure is stacked on the bridging recess portion and includes a groove, the heat pipe body of the heat pipe is positioned within the groove, and the second capillary structure is metallically bonded to the first capillary structure via the bonding layer.

In one embodiment, the heat pipe body of the heat pipe has an upper notch that is located on a first side of the heat pipe body, facing away from the first capillary structure.

In one embodiment, the heat pipe body of the heat pipe has a lower notch that is located on a second side of the heat pipe body, facing the first capillary structure.

In one embodiment, the first capillary structure is composed of microgrooves, metal mesh, sintered powder bodies, or sintered ceramic bodies.

In one embodiment, the longitudinal axis of the heat pipe is perpendicular to a bearing surface of the bridging recess.

In one embodiment, the heat conduction chamber comprises a base and a cover plate, wherein the base includes a base portion and a surrounding portion, the surrounding portion being connected to the periphery of the base portion, the bridging recess is located on the surrounding portion, and the cover plate is mounted to the surrounding portion of the base, forming a chamber between the base and the cover plate.

In one embodiment, the cover plate has a stamped recess portion, and the heat pipe is clamped between the stamped recess portion and the bridging recess portion.

Aspects of the present disclosure provide a method of manufacturing a communication-type thermal conduction device. The method includes forming a vapor chamber that includes a heat conduction chamber and a first capillary structure, forming a bridging recess portion on a side of the heat conduction chamber, forming a heat pipe that includes a heat pipe body and a second capillary structure, positioning the heat pipe body of the heat pipe on an extension portion of the first capillary structure, applying a metal powder to at least a portion of the extension portion of the first capillary structure and the second capillary structure, and sintering the metal powder to form a bonding layer that connects the second capillary structure to the first capillary structure.

In one embodiment, the first capillary structure is disposed within the heat conduction chamber and extends to the bridging recess portion.

In one embodiment, the heat pipe body is stacked on the first capillary structure of the heat conduction chamber at the bridging recess portion.

In one embodiment, the bonding layer is made of pre-sintered powder.

In one embodiment, the bonding layer is composed of gold, silver, copper, or iron powder.

In one embodiment, the heat pipe body of the heat pipe has an upper notch that is located on a first side of the heat pipe body, facing away from the first capillary structure.

In one embodiment, the first capillary structure is composed of the group including microgrooves, metal mesh, sintered powder bodies, or sintered ceramic bodies.

In one embodiment, the longitudinal axis of the heat pipe is perpendicular to a bearing surface of the bridging recess.

In one embodiment, the heat conduction chamber includes a base and a cover plate.

In one embodiment, the base includes a base portion and a surrounding portion, the surrounding portion being connected to the periphery of the base portion, the bridging recess is located on the surrounding portion, and the cover plate is mounted to the surrounding portion of the base, forming a chamber between the base and the cover plate.

In one embodiment, the cover plate has a stamped recess portion, and the heat pipe is clamped between the stamped recess portion and the bridging recess portion.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1 is an exploded view of the communication-type thermal conduction device according to one embodiment of the present disclosure.
FIG. 2 is a partial cross-sectional view of FIG. 1.
FIG. 3 is a perspective view of the communication-type thermal conduction device according to one embodiment of the present disclosure.
FIG. 4 is a partial exploded view of FIG. 3.
FIG. 5 is a partial cross-sectional view of FIG. 3.
FIGS. 6 to 8 are cross-sectional views illustrating the manufacturing method of the communication-type thermal conduction device shown in FIG. 3.
FIG. 9 is a partial cross-sectional view of the communication-type thermal conduction device according to one embodiment of the present disclosure.
FIG. 10 is a partial exploded view of the communication-type thermal conduction device according to one embodiment of the present disclosure.
FIG. 11 is a partial cross-sectional view of FIG. 10.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

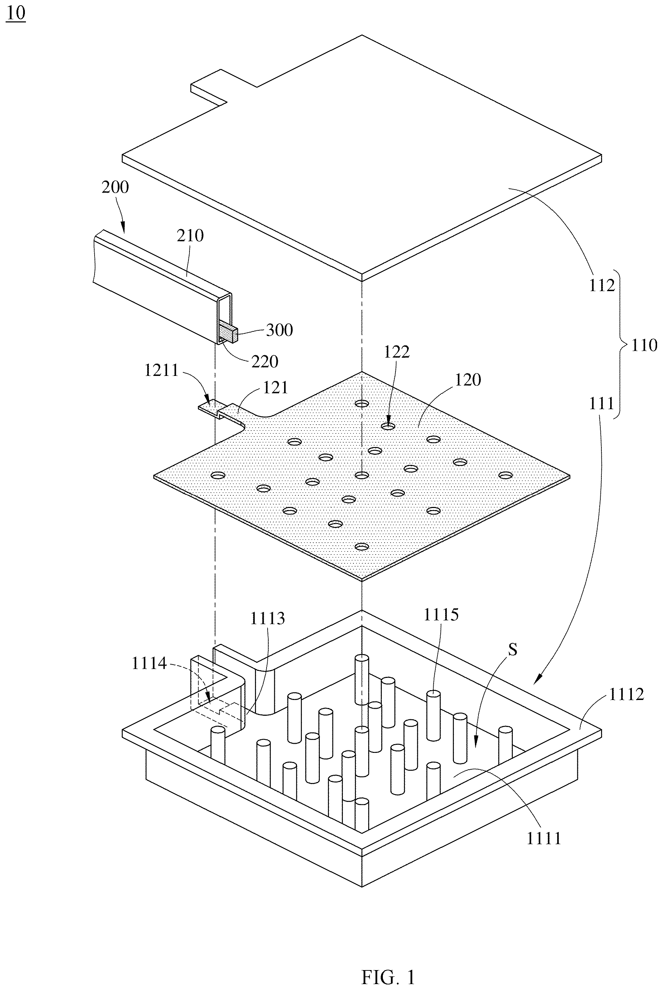

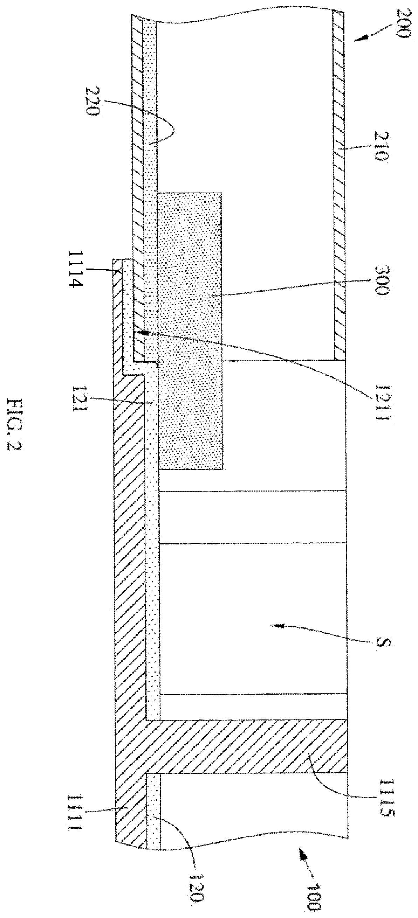

FIG. 1 is an exploded view of the communication-type thermal conduction device according to one embodiment of the present disclosure. FIG. 2 is a partial cross-sectional view of FIG. 1. In one embodiment, the communication-type thermal conduction device 10 includes a vapor chamber 100 and a heat pipe 200. As an example illustrated in FIG. 1, the heat pipe 200 is positioned horizontally, and a second capillary structure 220 is connected to a first capillary structure 120 through a powder-sintering process, but the embodiment is not limited thereto. In other embodiments, the heat pipe 200 may be oriented differently, such as placed vertically, and the second capillary structure 220 can be joined to the first capillary structure 120 using alternative methods, including brazing, welding, or other suitable bonding techniques.

In one embodiment, the vapor chamber 100 includes a heat conduction chamber 110 and the first capillary structure 120. Specifically, the heat conduction chamber 110 has a base 111 and a cover plate 112. The base 111 includes a base portion 1111, a surrounding portion 1112, and a bridging recessed portion 1113. The surrounding portion 1112 is connected to the periphery of the base portion 1111 so that the base portion 1111 and the surrounding portion 1112 enclose a recessed space S. The bridging recessed portion 1113 is located on the surrounding portion 1112, forming a downwardly recessed section with a bearing surface 1114. The cover plate 112 is mounted to the surrounding portion 1112 of the base 111, forming a chamber (not shown) between the base 111 and the cover plate 112 to accommodate working fluid (not shown). In one embodiment, the base 111 and the cover plate 112 form an assembled structure, but the embodiment is not limited thereto. In other embodiments, the base and the cover plate can be formed integrally.

In one embodiment, the first capillary structure 120 is stacked on one side of the base portion 1111 of the base 111. The first capillary structure 120 is facing toward the cover plate 112 and has an extension portion 121. The extension portion 121 is stacked on the bearing surface 1114 of the bridging recessed portion 1113 and has a groove 1211. The first capillary structure 120 can be a sintered ceramic body, but the embodiment is not limited thereto. In other embodiments, the first capillary structure can be selected from one of the followings: microgrooves, metal mesh, sintered powder bodies, sintered ceramic bodies, or a combination thereof. For example, the first capillary structure can be a composite of a sintered ceramic powder body and microgrooves. In one embodiment, the vapor chamber 100 only includes the first capillary structure 120 that is stacked on the base 111, but the embodiment is not limited thereto. In other embodiments, the vapor chamber may include another capillary structure on the side of the cover plate facing the base.

In one embodiment, the heat pipe 200 includes a heat pipe body 210 and the second capillary structure 220. The heat pipe body 210 is made of a thermally conductive metal, such as gold, silver, copper, or aluminum, and is stacked on the first capillary structure 120. The longitudinal axis of the heat pipe body 210 is perpendicular to the bearing surface 1114 and is positioned within the groove 1211. In other words, the heat pipe 200 is placed in an upright position. The upright placement of the heat pipe 200 reduces flow resistance, thereby enhancing the heat dissipation efficiency.

According to the embodiment, the second capillary structure 220 is stacked at the bottom of the heat pipe body 210. Therefore, the second capillary structure 220 is located on only one side of the heat pipe body 210, but the embodiment is not limited thereto. In other embodiments, the second capillary structure can be arranged to surround the inner surface of the heat pipe body 210.

In one embodiment, the second capillary structure 220 is a sintered powder body, but the embodiment is not limited thereto. In other embodiments, the second capillary structure may be selected from the group, including microgrooves, metal mesh, sintered powder bodies, and sintered ceramic bodies. For example, the second capillary structure may be a composite of a sintered powder body and a metal mesh.

In one embodiment, the communication-type thermal conduction device 10 further includes a bonding layer 300, which is a pre-sintered powder block stacked on the second capillary structure 220. The second capillary structure 220 is connected to the extension portion 121 of the first capillary structure 120 via the pre-sintered bonding layer 300 by a metallic bonding process. In an example, the bonding layer 300 is formed by applying a sprinkling powder over the first capillary structure 120 and the second capillary structure 220, followed by a sintering process, thereby allowing the first capillary structure 120 and the second capillary structure 220 to be connected through metallic bonding. In one embodiment, the bonding layer 300 is made of a pre-sintered powder block of either gold, silver, copper, or iron and has a porous structure. As an example illustrated in FIG. 2, a first side of the bonding layer 300 is metallically bonded to the second capillary structure 220, while the second side of the bonding layer 300 is metallically bonded to the extension portion 121 of the first capillary structure 120.

In one embodiment, the base 111 has multiple supporting structures 1115, such as support columns protruding from the base portion 1111. The first capillary structure 120 has multiple through-holes 122. The first capillary structure 120 is located within the chamber, and the supporting structures 1115 pass through these through-holes 122 to support the cover plate 112, preventing the vapor chamber 100 deformations while vacuuming.

According to the embodiment, when the first capillary structure 120 and the second capillary structure 220 are connected by metallically bonded via the bonding layer 300, the heat pipe body 210 is also in thermal contact with the first capillary structure 120. Therefore, besides integrating the first capillary structure 120 and the second capillary structure 220 for efficient heat transfer and improving the fluid transfer speed from the second capillary structure 220 to the first capillary structure 120, another heat conduction path is formed between the heat pipe body 210 and the first capillary structure 120, further enhancing the heat dissipation efficiency of the communication-type thermal conduction device 10 and the return flow speed of the liquid working fluid.

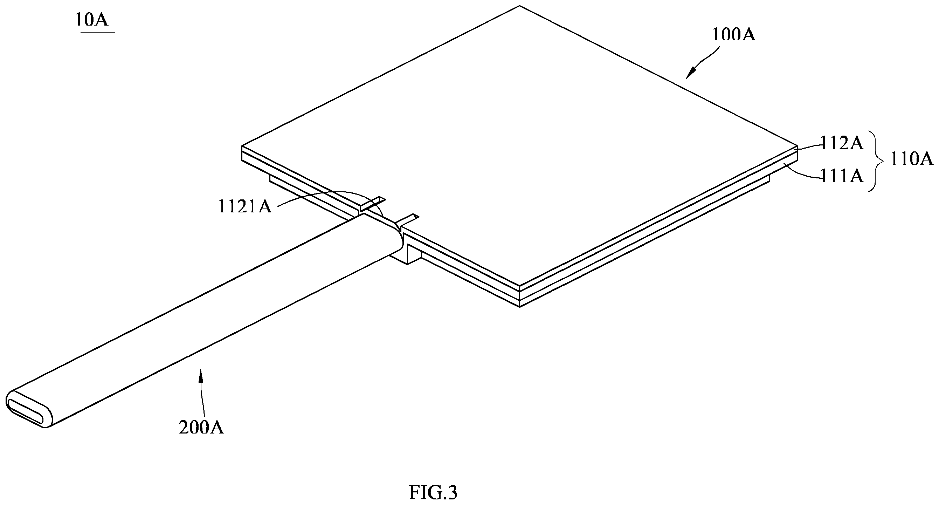

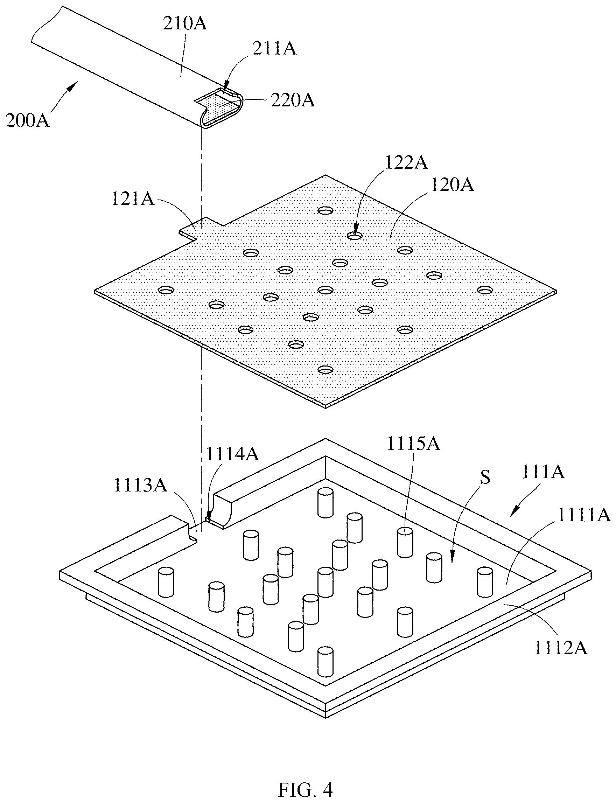

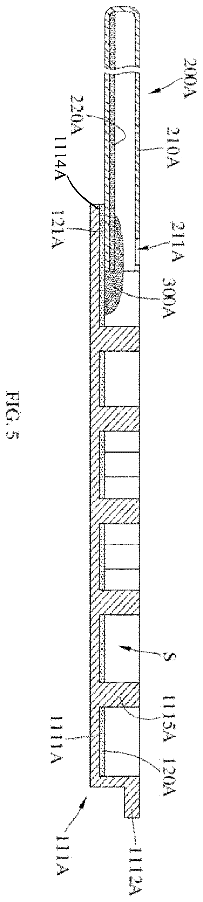

FIG. 3 is a perspective view of the communication-type thermal conduction device according to one embodiment of the present disclosure. FIG. 4 is a partial exploded view of FIG. 3. FIG. 5 is a partial cross-sectional view of FIG. 3. As illustrated in FIG. 3, the communication-type thermal conduction device 10 includes a vapor chamber 100A and a heat pipe 200A.

In one embodiment, the vapor chamber 100A includes a heat conduction chamber 110A and a first capillary structure 120A. Specifically, the heat conduction chamber 110A has a base 111A and a cover plate 112A. The base 111A includes a base portion 1111A, a surrounding portion 1112A, and a bridging recessed portion 1113A. The surrounding portion 1112A is connected to the periphery of the base portion 1111A so that the base portion 1111A and the surrounding portion 1112A enclose a recessed space S. The bridging recessed portion 1113A is located on the surrounding portion 1112A, forming a downward recess. The bridging recessed portion 1113A has a bearing surface 1114A. The cover plate 112A is mounted to the surrounding portion 1112A of the base 111A, forming a chamber (not shown) between the base 111A and the cover plate 112A. The chamber is used to contain a working fluid (not shown). In the embodiment, the base 111A and the cover plate 112A form an assembled structure, but the embodiment is not limited thereto. In other embodiments, the base and the cover plate can be formed integrally.

In one embodiment, the first capillary structure 120A is stacked on the side of the base portion 1111A. The first capillary structure 120A is facing toward the cover plate 112A and has an extension portion 121A. The extension portion 121A of the first capillary structure 120A is stacked on the bearing surface 1114A of the bridging recessed portion 1113A. The first capillary structure 120A can be a ceramic sintered body, but the embodiment is not limited thereto. In other embodiments, the first capillary structure can be selected from one of the followings: microgrooves, metal mesh, sintered powder bodies, sintered ceramic bodies, or a combination thereof. For example, the first capillary structure can be a composite of a ceramic powder sintered body and microgrooves. In one embodiment, the vapor chamber 100A only has the first capillary structure 120A that is stacked on the base 111A, but the embodiment is not limited thereto. In other embodiments, the vapor chamber can include another capillary structure on the side of the cover plate facing the base.

In one embodiment, the cover plate 112A has a stamped recessed portion 1121A corresponding to the bridging recessed portion 1113A of the base 111A. For example, the stamped recessed portion 1121A is formed through a stamping process and is used to fix the heat pipe 200A to the heat conduction chamber 110A.

In one embodiment, the heat pipe 200A includes a heat pipe body 210A and a second capillary structure 220A. The heat pipe body 210A can be made of thermally conductive metals such as gold, silver, copper, or aluminum and is stacked on the first capillary structure. The heat pipe body 210A has an upper notch 211A located on a first side of the heat pipe body 210A, facing away from the first capillary structure 120A. The second capillary structure 220A is stacked inside the heat pipe body 210A and at least partially extends into the exposed area of the upper notch 211A, allowing at least part of the second capillary structure 220A to be exposed where the upper notch 211A of the heat pipe body 210A is located.

According to the embodiment, the second capillary structure 220A is stacked at the bottom of the heat pipe body 210A. Therefore, the second capillary structure 220A is located on only one side of the heat pipe body 210A, but the embodiment is not limited thereto. In other embodiments, the second capillary structure can be arranged to surround the inner surface of the heat pipe body 210A.

In one embodiment, the second capillary structure 220A is a sintered powder body, but the embodiment is not limited thereto. In other embodiments, the second capillary structure may be selected from one of the followings: microgrooves, metal mesh, sintered powder bodies, sintered ceramic bodies, or a combination thereof. For example, the second capillary structure may be a composite of a sintered powder body and a metal mesh.

In one embodiment, the second capillary structure 220A is connected to the extension portion 121A of the first capillary structure 120A through a metallic bonding process. Specifically, the communication-type thermal conduction device 10A further includes a bonding layer 300A (See Fig. 5). The bonding layer 300A is made of gold, silver, copper, or iron powder and is formed into a porous structure through sintering or other suitable methods. In an example, the bonding layer 300A is formed by applying a sprinkling powder over the first capillary structure 120A and the second capillary structure 220A, followed by a sintering process, thereby allowing the first capillary structure 120A and the second capillary structure 220A to be connected through metallic bonding. As an example illustrated in FIG. 5, a first side of the bonding layer 300A is metallically bonded to the extension portion 121A of the first capillary structure 120A, while the second side is metallically bonded to the second capillary structure 220A.

In one embodiment, the base 111A has multiple supporting structures 1115A, such as support columns protruding from the base portion 1111A. The first capillary structure 120A has multiple through-holes 122A. The first capillary structure 120A is located within the chamber, and the supporting structures 1115A pass through these through-holes 122 to support the cover plate 112, preventing the vapor chamber 100 deformations while vacuuming.

According to the embodiment, when the first capillary structure 120A and the second capillary structure 220A are connected by metallically bonded via the bonding layer 300A, the heat pipe body 210A is also in thermal contact with the first capillary structure. Therefore, besides integrating the first capillary structure 120A and the second capillary structure 220A for efficient heat transfer and improving the fluid transfer speed from the second capillary structure 220A to the first capillary structure 120A, another heat conduction path is formed between the heat pipe body 210A and the first capillary structure 120A, further enhancing the heat dissipation efficiency of the communication-type thermal conduction device 10A and the return flow speed of the liquid working fluid.

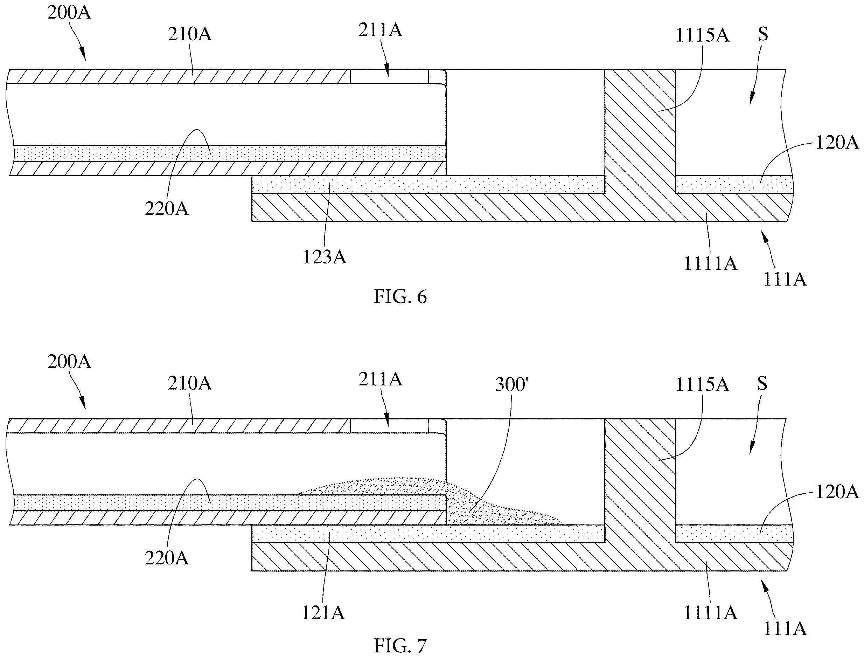

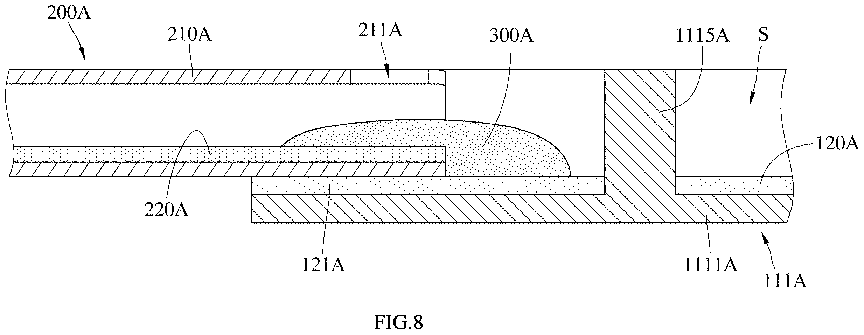

FIGS. 6 to 8 are cross-sectional views illustrating the manufacturing method of the communication-type thermal conduction device shown in FIG. 3. As an example illustrated in FIG. 6, the heat pipe body 210A of the heat pipe 200A is stacked on the extension portion 121A of the first capillary structure 120A. Further, as an example illustrated in FIG. 7, a metal powder 300' is applied on a portion of the extension portion 121A of the first capillary structure 120A and a portion of the second capillary structure 220A. Finally, as an example illustrated in FIG. 8, a sintering process is performed to solidify the metal powder into a bonding layer 300A, which connects the first capillary structure 120A and the second capillary structure 220A via metallic bonding.

According to the embodiment, the second capillary structure 220A of the heat pipe 200A is connected to the first capillary structure 120A through pre-sintered powder, but the embodiment is not limited thereto. In other embodiments, the second capillary structure 220A can be connected to the first capillary structure 120A through other suitable processes such as brazing or soldering.

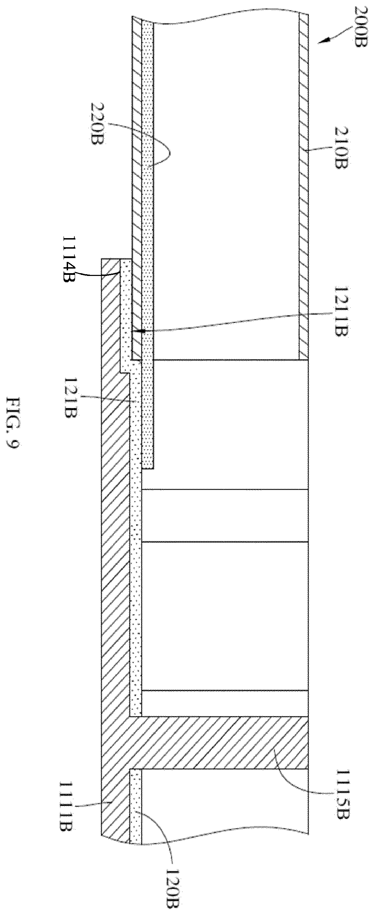

FIG. 9 is a partial cross-sectional view of the communication-type thermal conduction device according to one embodiment of the present disclosure. Because the communication-type thermal conduction device 10B of the embodiment is similar to the communication-type thermal conduction device 10A, the similarities will not be repeated, and only the differences will be described below.

In one embodiment, the extension portion 121B of the first capillary structure 120B is stacked on the bearing surface 1114B of the bridging recess 1113B and has a groove 1211B. The longitudinal axis of the heat pipe body 210B is perpendicular to the bearing surface 1114B and is positioned within the groove 1211B. In an example, the second capillary structure 220B, which can be a mesh capillary or fiber capillary, extends beyond the heat pipe body 210B. The second capillary structure 220B can be directly bonded to the first capillary structure 120B through processes such as sintering, spot welding, or other suitable process. Further, the second capillary structure 220B can be directly connected to the first capillary structure 120B, or, similar to the previous embodiment, it can be connected via an additional bonding layer.

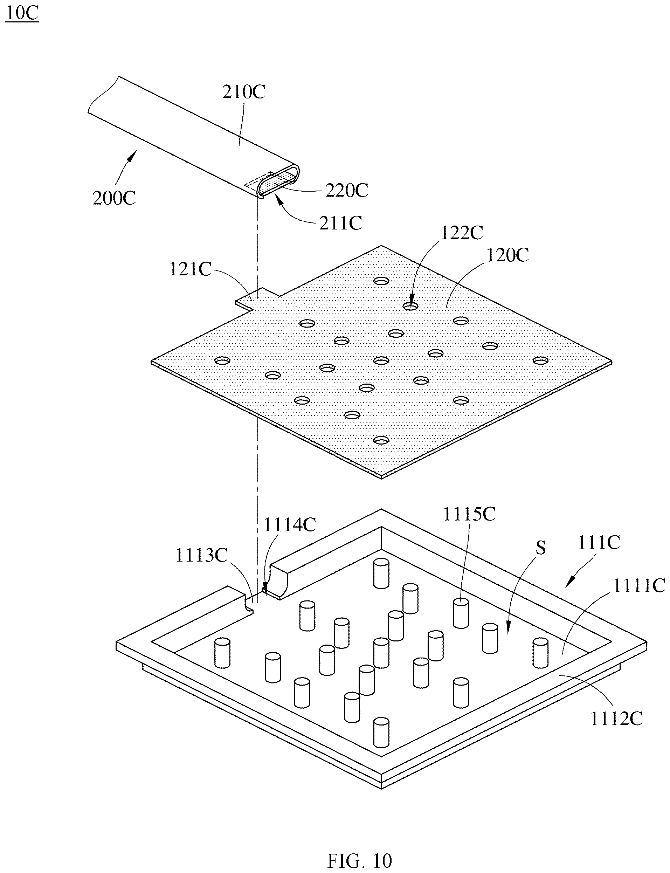

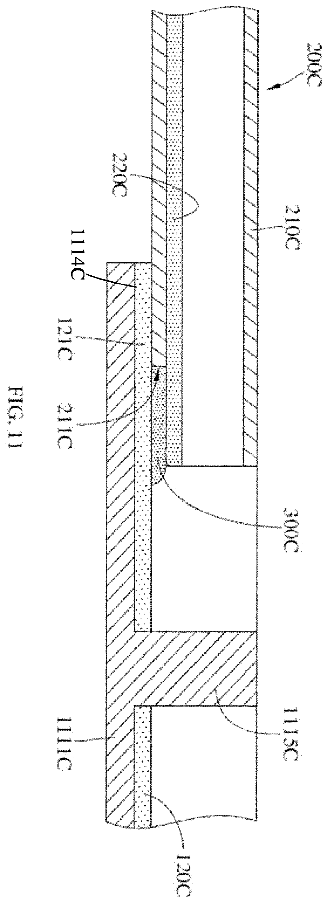

FIG. 10 is a partial exploded view of the communication-type thermal conduction device according to one embodiment of the present disclosure. FIG. 11 is a partial cross-sectional view of FIG. 10. Because the communication-type heat transfer device 10C in the embodiment is similar to the previously described device 10A, the similarities will not be repeated, and only the differences will be discussed below. As an example illustrated in FIG. 10 and FIG. 11, the communication-type thermal conduction device 10C includes a base 111C, a base portion 1111C, a surrounding portion 1112C, a bridging recess 1113C, a bearing surface 1114C, a supporting structure 1115C, a first capillary structure 120C, an extension portion 121C, and a through-hole 122C.

In one embodiment, the extension portion 121C of the first capillary structure 120C is stacked on the bearing surface 1114C of the bridging recess 1113C. The heat pipe body 210C has a lower notch 211C located on a second side of the heat pipe body 210C, facing the first capillary structure 120C. As an example illustrated in FIG. 10, the lower notch exposes a portion of the second capillary structure 220C. The heat pipe body 210C is stacked on the bearing surface 1114C so that part of the second capillary structure 220C is directly aligned with the extension portion 121C of the first capillary structure 120C. In one embodiment, the second capillary structure 220C is connected to the first capillary structure 120C via a bonding layer 300C. The bonding layer 300C is formed by applying a sprinkling powder over the first capillary structure 120C and the second capillary structure 220C, followed by a sintering process, thereby allowing the first capillary structure 120C and the second capillary structure 220C to be connected through metallic bonding, but the embodiment is not limited thereto. In other embodiments, if the extension portion has a groove, the second capillary structure can also be directly connected to the first capillary structure.

In the communication-type heat transfer device described in the above embodiments, the first and second capillary structures are connected through a bonding layer by metallic bonding. The heat pipe body is also in thermal contact with the first capillary structure. This arrangement not only integrates the first and second capillary structures into a unified heat transfer system to enhance fluid transfer speed from the second capillary structure to the first capillary structure but also creates an additional heat conduction pathway between the heat pipe body and the first capillary structure. Accordingly, the heat dissipation efficiency of the communication-type heat transfer device is improved, as well as the return flow speed of the liquid working fluid.

Further, compared to a configuration where the first capillary structure rests against the second capillary structure, in which case the two structures technically are not connected, the fluid tends to adhere more to the second capillary structure due to adhesion forces exceeding gravity. This configuration results in the first and second capillary structures functioning independently, causing fluid retention within the second capillary structure and leading to delayed fluid transfer. In contrast, the first and second capillary structures in the embodiment are connected through metallic bonding, eliminating the drawback of mere physical contact without substantial connection. This arrangement enhances the fluid transfer speed between the first and second capillary structures, thereby improving both the heat dissipation efficiency and the return flow speed of the liquid working fluid in the communication-type thermal conduction device.

In one embodiment, the heat pipe is positioned vertically, which reduces flow resistance, further enhancing the heat dissipation performance.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A communication-type thermal conduction device (10, 10A, 10C), comprising:
a vapor chamber (100, 100A, 100C) that includes a heat conduction chamber (110, 110A, 110C) and at least one first capillary structure (120, 120A, 120C), wherein the heat conduction chamber (110, 110A, 120C) includes a bridging recess portion (1113, 1113A, 1113C) located on a side thereof, and the first capillary structure (120, 120A, 120C) is disposed within the heat conduction chamber (110, 110A, 110C) and extends into the bridging recess portion (1113, 1113A, 1113C); and
a heat pipe (200, 200A, 200C) that includes a heat pipe body (210, 210A, 210C) and at least one second capillary structure (220, 220A, 220C), wherein the heat pipe body (210, 210A, 210C) is stacked on the first capillary structure (120, 120A, 120C) of the heat conduction chamber (110, 110A, 110C) at the bridging recess portion (1113, 1113A, 1113C), and the second capillary structure (220, 220A, 220C) is disposed within the heat pipe body (210, 210A, 210C) and is connected to the first capillary structure (120, 120A, 120C).

2. The communication-type thermal conduction device (10) of claim 1, further comprising a bonding layer (300), wherein a first side of the bonding layer (300) is connected to the first capillary structure (120) through metallic bonding, and the second side of the bonding layer (300) is connected to the second capillary structure (220) through metallic bonding.

3. The communication-type thermal conduction device (10) of claim 2, wherein the bonding layer (300) is made of pre-sintered powder.

4. The communication-type thermal conduction device (10) of claim 3, wherein the bonding layer (300) is composed of gold, silver, copper, or iron powder.

5. The communication-type thermal conduction device (10) of claim 2, wherein the first capillary structure (120) is stacked on the bridging recess portion (1113) and includes a groove (1211), the heat pipe body (210) of the heat pipe (200) is positioned within the groove (1211), and the second capillary structure (220) is metallically bonded to the first capillary structure (120) via the bonding layer (300).

6. The communication-type thermal conduction device (10A) of one of claims 1 to 5, wherein the heat pipe body (210A) of the heat pipe (200A) has an upper notch (211A) that is located on a first side of the heat pipe body (210A), facing away from the first capillary structure (120A).

7. The communication-type thermal conduction device (10C) of one of claims 1 to 5, wherein the heat pipe body (210C) of the heat pipe (200C) has a lower notch (211C) that is located on a second side of the heat pipe body (210C), facing the first capillary structure (120C).

8. The communication-type thermal conduction device (10) of one of claims 1 to 7, wherein the first capillary structure (120) is composed of microgrooves, metal mesh, sintered powder bodies, or sintered ceramic bodies.

9. The communication-type thermal conduction device (10) of one of claims 1 to 8, wherein the longitudinal axis of the heat pipe (200) is perpendicular to a bearing surface (1114) of the bridging recess (1113).

10. The communication-type thermal conduction device (10, 10A, 10C) of one of claims 1 to 9, wherein the heat conduction chamber (110) comprises a base (111) and a cover plate (112), wherein the base (111) includes a base portion (1111) and a surrounding portion (1112), the surrounding portion (1112) being connected to the periphery of the base portion (1111), the bridging recess (1113) is located on the surrounding portion (1112), and the cover plate (112) is mounted to the surrounding portion (1112) of the base (111), forming a chamber between the base (111) and the cover plate (112).

11. The communication-type thermal conduction device (10A) of claim 10, wherein the cover plate (112) has a stamped recess portion (1121A), and the heat pipe (200) is clamped between the stamped recess portion (1121A) and the bridging recess portion (1113).

12. A method of manufacturing a communication-type thermal conduction device (10, 10A, 10C), comprising:
forming a vapor chamber (100, 100A, 100C) that includes a heat conduction chamber (110, 110A, 110C) and a first capillary structure (120, 120A, 120C);
forming a bridging recess portion (1113, 1113A, 1113C) on a side of the heat conduction chamber (110, 110A, 110C),
forming a heat pipe (200, 200A, 200C) that includes a heat pipe body (210, 210A, 210C) and a second capillary structure (220, 220A, 220C);
positioning the heat pipe body (210, 210A, 210C) of the heat pipe (200, 200A, 200C) on an extension portion (121, 121A, 121C) of the first capillary structure (120, 120A, 120C);
applying a metal powder (300') to at least a portion of the extension portion (121, 121A, 121C) of the first capillary structure (120, 120A, 120C) and the second capillary structure (220, 220A, 220C); and
sintering the metal powder (300') to form a bonding layer (300, 300A, 300C) that connects the second capillary structure (220, 220A, 220C) to the first capillary structure (120, 120A, 120C).

13. The method of claim 12, wherein the first capillary structure (120) is disposed within the heat conduction chamber (110) and extends to the bridging recess portion (1113).

14. The method of claim 12 or 13, wherein the heat pipe body (210A) is stacked on the first capillary structure (120A) of the heat conduction chamber (110A) at the bridging recess portion (1113A).

15. The method of one of claims 12 to 14, wherein the bonding layer (300) is made of pre-sintered powder.

16. The method of claim 15, wherein the bonding layer (300) is composed of gold, silver, copper, or iron powder.

17. The method of claim 12, wherein the heat pipe body (210A) of the heat pipe (200A) has an upper notch (211A) that is located on a first side of the heat pipe body (210A), facing away from the first capillary structure (120A).

18. The method of claim 12, wherein the heat pipe body (210C) of the heat pipe (200C) has a lower notch (211C) that is located on a second side of the heat pipe body (210C), facing the first capillary structure (120C).

19. The method of one of claims 12 to 18, wherein the first capillary structure (120) is composed of the group including microgrooves, metal mesh, sintered powder bodies, or sintered ceramic bodies.

20. The method of one of claims 12 to 19, wherein the longitudinal axis of the heat pipe (200) is perpendicular to a bearing surface (1114) of the bridging recess (1113).

21. The method of one of claims 12 to 20, wherein the heat conduction chamber (110) includes a base (111) and a cover plate (112).

22. The method of claim 21, wherein the base (111) includes a base portion (1111) and a surrounding portion (1112), the surrounding portion (1112) being connected to the periphery of the base portion (1111), the bridging recess (1113) is located on the surrounding portion (1112), and the cover plate (112) is mounted to the surrounding portion (1112) of the base (111), forming a chamber between the base (111) and the cover plate (112).

23. The method of claim 21 or 22, wherein the cover plate (112A) has a stamped recess portion (1121A), and the heat pipe (200) is clamped between the stamped recess portion (1121A) and the bridging recess portion (1113).
